# EUROPEAN PATENT APPLICATION

(11) **EP 2 248 662 A1**
(43) Date of publication of application: **10.11.2010**
(21) Application number: 10161285.1
(22) Date of filing: 28.04.2010
(51) Int. Cl.: B32B 15/01, H01L 31/00

(54) **Metal composite substrate and method of producing the same**

(30) Priority: 01.05.2009 JP 2009111862
(71) Applicant: Fujifilm Corporation, Minato-ku Tokyo (JP)
(72) Inventor: Sawada, Hirokazu, Shizuoka (JP); Uesugi, Akio, Shizuoka (JP)
(74) Representative: HOFFMANN EITLE

(57) **Abstract**

A metal composite substrate includes a core made of a metal having higher strength than aluminum at elevated temperatures of at least 300°C and an aluminum or aluminum alloy layer covering an entire surface of the core, and an anodized film is formed at a surface of the aluminum or aluminum alloy layer. The metal composite substrate having the anodized surface film can produce with high efficiency an insulating flexible support by a roll-to-roll process and has good flatness during the high-temperature heat treatment.

## Description

### TECHNICAL FIELD

The present invention relates to a metal composite substrate. More specifically, the present invention relates to a metal composite substrate which has front and rear surfaces covered with an anodized aluminum alloy and which exhibits excellent strength properties at high temperatures.

The semiconductor substrate is required to have high insulating properties and heat dissipation properties. The semiconductor substrate preferably also has high flexibility. In cases where an aluminum alloy is used for the semiconductor substrate, the aluminum alloy which is a material having high electrical conductivity cannot satisfy the required insulating properties when used as it is, but the insulating properties are drastically improved by providing an anodized surface layer. The aluminum alloy is a material having a good thermal conductivity and has therefore excellent heat dissipation properties and also has good flexibility by selecting an adequate plate thickness. When used to manufacture the semiconductor substrate, the aluminum alloy may be treated at high temperatures and in such a case requires heat resistance.

For example, resin materials having a comparatively high heat resistance such as polyimides have excellent insulating properties and may be therefore used for the semiconductor substrate but cannot withstand excessively high temperatures. The aluminum alloy substrate can withstand a certain degree of high temperatures and is also excellent in this point.

Thin-film solar cells are known as the semiconductor devices particularly requiring heat resistance. Solar cells are broadly classified into three types including (1) monocrystalline silicon solar cells, (2) polycrystalline silicon solar cells, and (3) thin-film solar cells. The monocrystalline silicon solar cells and polycrystalline silicon solar cells use a silicon wafer for the substrate, whereas the thin-film solar cells use a variety of substrates including glass substrate, metal substrate and resin substrate and have a thin light-absorbing layer formed on any of these substrates.

Thin films of silicon materials including amorphous silicon and nanocrystalline silicon and those of compounds including CdS/CdTe, CIS(Cu-In-Se), and CIGS(Cu-In-Ga-Se) are used for the light-absorbing layer. Use of a flexible substrate enables continuous manufacture of flexible solar cells by a roll-to-roll process in which an insulating layer and other thin films are formed as the substrate is wound into a roll.

The substrates mainly used for the thin-film solar cells are glass substrates. However, the glass substrates are liable to fracture, requires adequate care in handling and lacks in flexibility. Recently, solar cells draw attention as the power supply source for houses or other buildings, and the solar cells are desired to have a larger size, a larger surface area and a reduced weight in order to ensure enough power supply. Under the circumstances, flexible substrate materials which are not liable to fracture and can achieve weight reduction, as exemplified by a resin substrate, an aluminum alloy substrate and a substrate obtained by cladding a substrate of iron or the like with aluminum have been proposed.

A known method involves forming an anodized layer or other insulting layer on the aluminum alloy substrate, and then forming a thin-film solar cell layer thereon.

In order to form the compound thin film as the light-absorbing layer, a compound is disposed on the substrate and sintered at 350°C to 650°C in accordance with the type of compound used. Sintering at a temperature of 350 to 600°C and a line speed of 4 to 20 m/min is preferred in order to form, for example, the CIGS layer in the continuous production, and it is desirable to use a substrate material withstanding such temperatures.

However, it is difficult to ensure compatibility between high strength and high sintering temperature, because the shape of the aluminum substrate is difficult to hold by lack of strength at elevated temperatures.

Exemplary known aluminum alloys having high strength at elevated temperatures include those containing iron and/or manganese, and JP 2008-81794 A proposes an improvement using an aluminum alloy containing 0.25 to 0.35 wt% of silicon, 0.05 to 0.3 wt% of iron, 0.3 to 0.5 wt% of copper, 1.2 to 1.8 wt% of manganese, 0.05 to 0.4 wt% of scandium, and 0.05 to 0.2 wt% of zirconium, the balance being aluminum and impurities; an aluminum alloy further containing 0.05 to 0.2 wt% of vanadium; an aluminum alloy having scandium concentration of 0.07 to 0.15 wt%; an aluminum alloy having a zirconium concentration of 0.07 to 0.1 wt%; and an aluminum alloy having a vanadium concentration of 0.07 to 0.1 wt%. JP 2000-349320 A proposes specifying the shape of micropores in an anodized film in a method of increasing the mechanical strength of the anodized film provided on a flexible solar cell substrate using an aluminum alloy. The subject matter is an aluminum alloy-based insulating material having a pore-bearing anodized film with a thickness of at least 0.5 µm formed on a surface of an aluminum substrate, the anodized film having a plurality of voids extending within the anodized film in directions substantially orthogonal to the axes of the pores.

JP 2000-349320 A describes that an oxalic acid bath or a sulfuric acid bath may be applied for anodizing treatment but that the anodized film formed has a different internal structure depending on the alloy and treatment conditions and as a result various withstand voltage values are obtained. JP 2000-349320 A also describes that a higher withstand voltage can be achieved by a structure in which the pores and/or voids after anodizing treatment are filled with silicon oxide.

JP 2007-502536 A refers to a coated metallic material suitable to manufacture a flexible solar cell and describes a coated steel product which has a coating comprising an electrically insulating layer doped with an alkali metal or a mixture of alkali metals, the thermal expansion coefficient of the metallic material being less than 12 × 10⁻⁶K⁻¹ in the temperature range of 0 to 600°C, the electrically insulating layer comprising at least one oxide layer and the oxide layer consisting essentially of any of the following dielectric oxides: Al₂O₃, TiO₂, HfO₂, Ta₂O₅ and Nb₂O₅ or mixtures of these oxides, preferably Al₂O₃ and/or TiO₂. JP 2007-502536 A also describes a method of manufacturing a steel product coated with a metal oxide by a roll-to-roll process.

JP 11-229187 A describes a substrate for electronic materials which includes a base and a surface insulating layer made of at least one metal oxide and other nonconductive material and which has excellent insulating properties. It is also described to use for the metal oxide one obtained by anodization at the surface of an aluminum substrate.

JP 2000-49372 A describes forming an insulating layer having a thickness of at least 0.5 µm and a centerline mean roughness Rₐ of 0.5 to 200 µm on a surface of a metal plate comprising an aluminum alloy plate. It is also described to form an anodized film on an aluminum substrate and to use it as the insulating layer.

JP 11-97724 A describes an amorphous solar cell substrate which uses an aluminum substrate having an anodized film with topographical features.

JP 2000-286432 A describes a solar cell substrate having a micropore-bearing anodized film.

### SUMMARY OF THE INVENTION

Of the semiconductor substrates, glass substrates have conventionally been very often used for devices which require high temperature treatment in the production process as typified by thin-film solar cells. However, it is difficult to dispose such glass substrates in a curved shape for lack of flexibility and methods of providing a metal substrate have been proposed as in JP 2007-502536 A, JP 11-229187 A, JP 2000-49372 A, JP 11-97724A and JP 2000-286432 A. However, in cases where thin-film solar cells which require formation of a light-absorbing layer at high temperatures are to be produced, handling at high temperatures and hence their consistent production are difficult because a substrate which uses an aluminum film having an insulating anodized surface layer as described in JP 11-229187 A, JP 2000-49372 A, JP 11-97724 A, and JP 2000-286432 A has difficulty in holding the shape for lack of strength at high temperatures.

A method of providing an insulating layer in a steel product as described in JP 2007-502536 A has also been proposed but the insulating performance is not sufficient and no power generation voltage can be obtained by connecting solar cells in series on substrates.

High-strength aluminum alloys as in JP 2008-81794 A have also been proposed, but it is difficult to form a light-absorbing layer at a temperature of as high as 500°C or more and particularly flatness cannot be held. In addition, iron and manganese added to the aluminum metal easily produce intermetallic compounds, consequently leading to the fatal outcome that the intermetallic compounds cause a defect of the anodized film formed at the aluminum metal surface to reduce the insulating resistance.

The present invention provides a support or substrate obtained by anodizing a composite metal support having the entire surface coated with aluminum by hot dipping or the like, as the material which is suitable for use as a semiconductor material such as a thin-film solar cell substrate, has high strength at elevated temperatures, and particularly maintains good flatness and withstands handling at high temperatures. It has been thus found that a lithographic printing plate support which has good surface hardness and good adhesion to the image recording layer and does not cause the reduction of the support strength or flatness even under the high temperature burning treatment, and an insulating substrate for semiconductor devices which has high insulating performance and high strength at elevated temperatures, and is excellent in the handleability at elevated temperatures and in the flatness after high-temperature heat treatment are obtained. The present invention has been thus completed.

An object of the present invention is to provide a composite substrate which has an anodized surface film-bearing aluminum or aluminum alloy layer and which exhibits high strength at elevated temperatures and excellent withstand voltage characteristics. Another object of the present invention is to provide a method of producing the composite substrate.

The metal composite substrate having the aluminum or aluminum alloy surface layer and its production method have the following features:
(1) A metal composite substrate comprising: a core comprising a metal having higher strength than aluminum at elevated temperatures of at least 300°C; and an aluminum or aluminum alloy layer covering an entire surface of the core, wherein an anodized film is formed at a surface of the aluminum or aluminum alloy layer.
(2) The metal composite substrate according to (1), wherein the core comprises a heat resisting steel or a stainless steel.
(3) The metal composite substrate according to (1) or (2), wherein the anodized film is a porous anodized film with a thickness of 1 to 50 µm.
(4) The metal composite substrate according to any one of (1) to (3), wherein the anodized film is further sealed in an aqueous boric acid solution.
(5) A semiconductor substrate comprising the metal composite substrate according to any one of (1) to (4).
(6) A solar cell comprising the metal composite substrate according to any one of (1) to (4).
(7) A thin-film solar cell comprising: the metal composite substrate according to any one of (1) to (4); and a light-absorbing layer and an electrode layer formed on the metal composite substrate.
(8) The thin-film solar cell according to (7), wherein the light-absorbing layer is formed on the metal composite substrate via a backside electrode layer and contains a compound selected from the group consisting of CdS/CdTe, CIS and CIGS.
(9) A method of producing a metal composite substrate comprising: plating an entire surface of a core comprising a metal having higher strength than aluminum at elevated temperatures of at least 300°C with aluminum or an aluminum alloy to form an aluminum or aluminum alloy layer; and subjecting a surface of the aluminum or aluminum alloy layer to anodizing treatment, rinsing treatment and drying treatment.
(10) The method according to (9), wherein the plating is hot-dip plating.

The composite substrate having a surface layer of aluminum or an aluminum alloy according to the present invention is one which has an anodized surface film and has good flatness during the high-temperature heat treatment. The metal composite substrate of the present invention can be used to manufacture with high efficiency, by a roll-to-roll process, a lithographic printing plate which withstands high-temperature burning treatment and an insulating flexible support for use in a solar cell substrate which withstands vapor deposition under high temperatures.

The metal composite substrate of the present invention has the core entirely coated with aluminum or an aluminum alloy and therefore has the advantage that the material of the core or the contact surface does not dissolve compared to the substrate which has only one surface or two main surfaces covered with aluminum or an aluminum alloy and in which the material of the core or the contact surface dissolves from the end portions where the contact surface between the core and the aluminum layer is exposed during the anodized film-forming step carried out in the electrolytic solution. On the other hand, in order to avoid this defect by using a substrate which has one surface or two main surfaces comprising aluminum or an aluminum alloy, a preliminary step for preventing end surfaces from contacting the electrolytic solution is necessary. More specifically, a step for covering the end surfaces with a protective material having excellent chemical resistance is necessary. In cases where the end surfaces are covered with a protective material, the end portions are more likely to have a larger thickness due to the protective material used, and consequently there is a high possibility that breakage will occur during the handling of the substrate which is made to travel while contacting the pass rolls. In cases where the protective material does not sufficiently adhere to the end surfaces, the electrolytic solution is more likely to enter the gap to cause dissolution at the end surfaces. The inventive method can avoid these defects. In cases where the end surfaces must also have insulating properties, the anodized film formed via the aluminum or aluminum alloy layer with which the end surfaces are covered also ensures the insulating properties of the end surfaces. The anodized film formed via the aluminum or aluminum alloy layer with which the end surfaces are also covered has the effect of protecting the end surfaces against corrosion and dissolution in cases where chemical treatment is carried out in a step following anodizing treatment.

### BRIEF DESCRIPTION OF THE DRAWINGS

FIG. 1A is a cross-sectional view of a metal composite substrate according to an embodiment of the present invention in which an anodized film is formed on the entire surface of a core.
FIG. 1B shows another embodiment in which an anodized film is formed on both the main surfaces.
FIG. 2 is a cross-sectional view showing an example of the general configuration of a thin-film solar cell for which the substrate of the present invention can be used.
FIG. 3 schematically shows an exemplary device that may be used in anodizing treatment and electrochemical sealing treatment of the present invention.

### DETAILED DESCRIPTION OF THE INVENTION

### 1. Core Material

Metallic materials which have higher strength than aluminum alloys at elevated temperatures of at least 300°C are used for the core of the present invention. The core material is selected from, for example, steels, titanium and nickel. The material used is desirably suitable for practical use, inexpensive and flexible and therefore it is preferred to use steels such as mild steels, heat resisting steels and stainless steels. Of these steels, heat resisting steels and stainless steels are more preferred in terms of the heat resistance.

The mild steels are low-carbon steels and, for example, SS400 can be used.

The heat resisting steels contain chromium, nickel, cobalt, tungsten and the like in amounts of several percents, and are classified into austenitic steels, ferritic steels and martensitic steels. Heat resisting steels such as austenitic steels and ferritic steels are desirably used for the plate material. Exemplary heat resisting austenitic steels that may be preferably used include SUH309, SUH310, SUH330, SUH660 and SUH661. Exemplary heat resisting ferritic steels that may be preferably used include SUH21, SUH409 and SUH446.

Stainless steels are those containing at least 11% of chromium and optionally nickel. The stainless steels are classified into austenitic, ferritic and martensitic stainless steels. Exemplary austenitic stainless steels that may be used include SUS304, SUS316, SUS310, SUS309, SUS317, SUS321 and SUS347. Exemplary ferritic stainless steels that may be used include SUS430, SUS405, SUS410, SUS436 and SUS444. Exemplary martensitic stainless steels that may be used include SUS403, SUS440, SUS420 and SUS410. Of these, austenitic and ferritic stainless steels are preferred in the case of using as flexible plates. Austenitic stainless steels are preferred particularly in the case of improving the strength at elevated temperatures. SUS304 and SUS316 are commonly used but SUS310 and SUS309 are preferably used particularly in cases where higher heat resistance is required. The plate thickness influences the flexibility and is therefore preferably made as small as possible so long as excessive lack of rigidity is not caused. In terms of flexibility, the thickness is not more than 0.5 mm, preferably not more than 0.3 mm and more preferably not more than 0.1 mm, Reduction of the plate thickness is also preferred in terms of material costs. However, the lower limit is preferably 0.03 mm in order to ensure the minimum rigidity during the handling.

### 2. Surface Layer Material (Aluminum or Aluminum Alloy)

Aluminum or an aluminum alloy for use in the present invention preferably contains no unwanted intermetallic compounds. More specifically, aluminum with a purity of at least 99 wt% which contains few impurities is preferably used. For example, aluminum with a purity of 99.99 wt%, aluminum with a purity of 99.96 wt%, aluminum with a purity of 99.9 wt%, aluminum with a purity of 99.85 wt%, aluminum with a purity of 99.7 wt%, and aluminum with a purity of 99.5 wt% are preferably used. Alternatively, elements which do not easily form intermetallic compounds may also be added. For example, an aluminum alloy obtained by adding 2.0 to 7.0 wt% of magnesium to 99.9 wt% of aluminum may also be used. In addition to magnesium, elements such as copper and silicon having a high solid solubility limit may be selected for addition. In cases where the metal composite substrate is applied to a lithographic printing plate support, an element capable of controlling the electrochemical graining properties may be added to the surface layer aluminum. Typical examples thereof include copper and silicon. In cases where the metal composite substrate is applied to a semiconductor support having insulating properties, the aluminum purity can be improved to prevent the formation of intermetallic compounds due to deposits, thus enhancing the soundness of the insulating layer. This is because, in cases where an aluminum alloy is anodized, intermetallic compounds serve as starting points to increase the chances of causing insulation failure.

The surface layer thickness must be larger than the thickness of the anodized film to be formed and should be at least 10 µm. The surface layer preferably has a thickness of at least 20 µm and more preferably at least 30 µm. The thickness is preferably not more than 100 µm although its upper limit is restricted by the step used in cases where the surface layer is formed by hot dipping.

### 3. Composite Material

Exemplary production methods that are practically known to form a composite material having a core made of a material with high strength at elevated temperatures and a surface layer made of aluminum or an aluminum alloy include clad rolling and hot dipping, and hot dipping is more preferred because end faces are easily protected.

The composite material preferably has a thickness of 20 µm to 5000 µm and a width of 100 mm to 2000 mm.

The aluminum layer preferably has a mirror-finished surface and the surface roughness Rₐ is preferably from 0.1 nm to 2 µm and more preferably from 1 nm to 0.3 µm.

The composite material is required to have a tensile strength under heat treatment at 500°C or more of at least 5 MPa, and desirably has a tensile strength of at least 10 MPa.

In order to prevent creep from occurring during the heat treatment at 500°C or more, the composite material held at 500°C for 10 minutes preferably has a strength causing up to 0.1% of plastic deformation, of at least 0.2 MPa, more preferably at least 0.4 MPa and even more preferably at least 1 MPa.

Alstar steel sheet and Alstar stainless steel sheet from Nisshin Steel Co., Ltd. and ALSHEET from Nippon Steel Corporation are known composite materials produced by aluminum hot dipping.

The aluminum surface layer may be mirror-finished and exemplary methods of mirror-finishing are described in JP 4212641 B, JP 2003-341696 A, JP 7-331379 A, JP 2007-196250 A and JP 2000-223205 A.

### 4. Surface Treatment Method (Formation of Anodized Film)

It is preferred for the surface layer aluminum to be optionally subjected to cleaning treatment for removing stains or the like using an acid or an organic solvent.

Then, anodizing treatment is carried out in acid solutions such as sulfuric acid, phosphoric acid and oxalic acid. The anodized film preferably has a thickness of at least 5 µm and more preferably at least 10 µm. However, it is not preferred for the anodized film to have an excessively large thickness because the formation of the film is a costly, time-consuming work. In practice, the anodized film preferably has a thickness of up to 50 µm and more preferably up to 30 µm.

The electrolytic solution that may be used in anodizing treatment is preferably an aqueous sulfuric acid or oxalic acid solution. Oxalic acid is excellent in the soundness of the film. On the other hand, sulfuric acid is excellent in the productivity in continuous treatment.

Preferred anodizing treatment conditions are described below.

It is possible to use an AC, a DC or an AC/DC superimposed current for anodizing treatment, and the current may be applied at a constant rate from the initial stage of electrolysis or using an incremental method. However, a method using a DC is particularly preferred.

Anodizing treatment is preferably carried out at a time on all of the front, rear and two lateral surfaces of the composite sheet in order to simplify the surface treatment. However, anodizing treatment may be carried out first on the front and rear surfaces and then on the two lateral surfaces. Alternatively, the front, rear and lateral surfaces of the composite sheet may be sequentially anodized.

It is possible to use a known anodizing method for the electrolyte flow rate on the aluminum surface and its application method, electrolytic cell, electrode, and method of controlling the electrolyte concentration.

Exemplary methods are described in JP 2002-362055 A, JP 2003-001960 A, JP 6-207299 A, JP 6-235089 A, JP 6-280091 A, JP 7-278888 A, JP 10-109480 A, JP 11-106998 A, JP 2000-17499 A, JP 2001-11698 A, and JP 2005-60781 A. It is possible to use, for example, aluminum, carbon, titanium, niobium, zirconium, and stainless steel for the counter electrode (cathode) of the composite sheet in which aluminum is used for the anode. It is possible to use, for example, lead, platinum, and iridium oxide for the counter electrode (anode) when aluminum is used for the cathode.

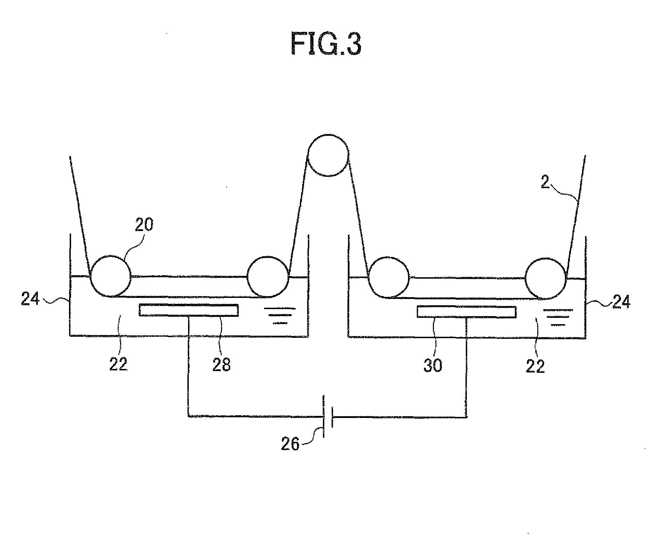

FIG. 3 shows an exemplary device that may be used in anodizing treatment and electrochemical sealing treatment of the present invention. This device is used to electrochemically treat a surface layer of aluminum or an aluminum alloy formed on a core in a composite sheet 2 which is made to travel through a plurality of pass rolls 20 within an electrolytic cell 24 containing an electrolytic solution 22, with a DC power supply 26 connected to an anode 28 and a cathode 30 disposed so as to face the composite sheet 2.

### (a) Anodizing Treatment in Aqueous Sulfuric Acid Solution

The composite sheet serving as an anode is anodized under the conditions of a sulfuric acid concentration of 100 to 300 g/L and preferably 120 to 200 g/L (and an aluminum ion concentration of 0 to 10 g/L), a solution temperature of 10 to 55°C (and preferably 20 to 50°C), a current density of 10 to 100 A/dm² (and preferably 20 to 80 A/dm²), and an electrolysis time of 5 to 300 seconds (and preferably 5 to 120 seconds). The voltage between the composite sheet and the counter electrode is preferably from 10 to 150 V and varies with, for example, the electrolyte composition, solution temperature, flow rate at the aluminum interface, power supply waveform, distance between the composite sheet and the counter electrode, and electrolysis time.

The aluminum ions electrochemically or chemically dissolve in the electrolytic solution but it is particularly preferable to add aluminum sulfate to the electrolytic solution in advance. Trace elements contained in the aluminum alloy may dissolve therein.

### (b) Anodizing Treatment in Aqueous Oxalic Acid Solution

The aqueous oxalic acid solution preferably contains 10 to 150 g/L (and preferably 30 to 100 g/L) of oxalic acid and 0 to 10 g/L of aluminum ions. The composite sheet serving as an anode is anodized under the conditions of a solution temperature of 10 to 55°C (and preferably 10 to 30°C), a current density of 0.1 to 50 A/dm² (and preferably 0.5 to 10 A/dm²), and an electrolysis time of 1 to 100 minutes (and preferably 30 to 80 minutes). The voltage between the composite sheet and the counter electrode is preferably from 10 to 150 V and varies with, for example, the electrolyte composition, solution temperature, flow rate at the aluminum interface, power supply waveform, distance between the composite sheet and the counter electrode, and electrolysis time.

The aluminum ions electrochemically or chemically dissolve in the electrolytic solution but aluminum oxalate may be added to the electrolytic solution in advance. Trace elements contained in the aluminum alloy may dissolve therein.

### Boric Acid Electrolysis (Sealing Treatment)

Particularly in the case of enhancing the insulating properties, the anodized composite sheet is desirably sealed in a boric acid solution.

Electrochemical methods and chemical methods are known for sealing treatment, but an electrochemical method using aluminum of the composite sheet for the anode (anodizing treatment) is particularly preferred.

The electrochemical method is preferably a method in which sealing treatment is carried out by applying a direct current to the aluminum or the aluminum alloy serving as the anode. The electrolytic solution is preferably an aqueous boric acid solution, and an aqueous solution obtained by adding a sodium-containing borate to the aqueous boric acid solution is preferred. Examples of the borate include disodium octaborate, sodium tetraphenylborate, sodium tetrafluoroborate, sodium peroxoborate, sodium tetraborate and sodium metaborate. These borates are available in the form of anhydride or hydrate.

It is particularly preferred to use, as the electrolytic solution for sealing treatment, an aqueous solution obtained by adding 0.01 to 0.5 mol/L of sodium tetraborate to an aqueous solution containing 0.1 to 2 mol/L boric acid. The electrolytic solution preferably contains 0 to 0.1 mol/L of aluminum ions dissolved therein. The aluminum ions are chemically or electrochemically dissolved in the electrolytic solution by sealing treatment but a method of electrolysis by previous addition of aluminum borate is particularly preferred. Trace elements contained in the aluminum alloy may dissolve therein.

Preferred conditions for sealing treatment include a solution temperature of 10 to 55°C (and preferably 10 to 30°C), a current density of 0.01 to 5 A/dm² (and preferably 0.1 to 3 A/dm²), and an electrolysis time of 0.1 to 10 minutes (and preferably 1 to 5 minutes).

It is possible to use an AC, a DC or an AC/DC superimposed current, and the current may be applied at a constant rate from the initial stage of electrolysis or using an incremental method. However, a method using a DC is particularly preferred. A current may be applied by a constant voltage process or a constant current process.

The voltage between the composite sheet and the counter electrode is preferably from 100 to 1000 V and varies with, for example, the electrolyte composition, solution temperature, flow rate at the aluminum interface, power supply waveform, distance between the composite sheet and the counter electrode, and electrolysis time.

Sealing treatment is preferably carried out at a time on all of the front, rear and end surfaces of the composite sheet in order to simplify the surface treatment. However, the front, rear and end surfaces of the composite sheet may be sequentially sealed.

It is possible to use the known anodizing methods described in connection with anodizing treatment and sealing methods for the electrolyte flow rate on the aluminum surface and its application method, electrolytic cell, electrode, and method of controlling the electrolyte concentration. The film thickness in the course of anodizing treatment in an aqueous boric acid solution containing sodium borate is preferably at least 100 nm and more preferably at least 300 nm. The upper limit is the thickness of the anodized porous film and is, in practice, 1 µm in terms of production costs.

A metal composite material for use in semiconductor substrates and in particular a metal composite material for use in thin-film solar cell substrates which requires high strength at elevated temperatures and has the merit of flexibility can be thus provided.

It is also possible to obtain, by a preferred chemical method, a structure in which the pores and/or voids after anodizing treatment are filled with silicon oxide. It is also possible to use a method of filling with silicon oxide which involves applying a solution containing a Si-O bond-bearing compound or immersing in an aqueous sodium silicate solution (aqueous solution containing 1 to 5 wt% of NO. 1 sodium silicate or No. 3 sodium silicate, 20 to 70°C) for 1 to 30 seconds, rinsing with water, drying, and further baking at 200 to 600°C for 1 to 60 minutes.

An exemplary chemical method that may be preferably used includes a method in which the aqueous sodium silicate solution is replaced by a 1 to 5 wt% aqueous solution containing sodium hexafluorozirconate and/or sodium dihydrogen phosphate or a mixture thereof at a mixing weight ratio of 5:1 to 1:5, and sealing treatment is carried out by immersion in the latter solution at 20 to 70°C for 1 to 60 seconds.

### 5. Method of Producing Semiconductor Substrate

The desired method of producing a semiconductor substrate according to the present invention is a method of producing a metal composite substrate for semiconductor devices in which anodizing treatment, rinsing treatment and drying treatment are carried out on a surface of the composite sheet which includes a core made of a metal having higher strength than aluminum at elevated temperatures of at least 300°C and a surface layer of aluminum or an aluminum alloy formed by plating the entire surface of the core with the aluminum or the aluminum alloy.

In another method, a first anodizing treatment, rinsing treatment, a second anodizing treatment, rinsing treatment and drying treatment are carried out on a surface of the composite sheet which includes a core made of a metal having higher strength than aluminum at elevated temperatures of at least 300°C and a surface layer of aluminum or an aluminum alloy formed by plating the entire surface of the core with the aluminum or the aluminum alloy. The first anodizing treatment is preferably carried out with oxalic acid or sulfuric acid, and the second anodizing treatment is preferably carried out with an aqueous boric acid solution containing sodium borate.

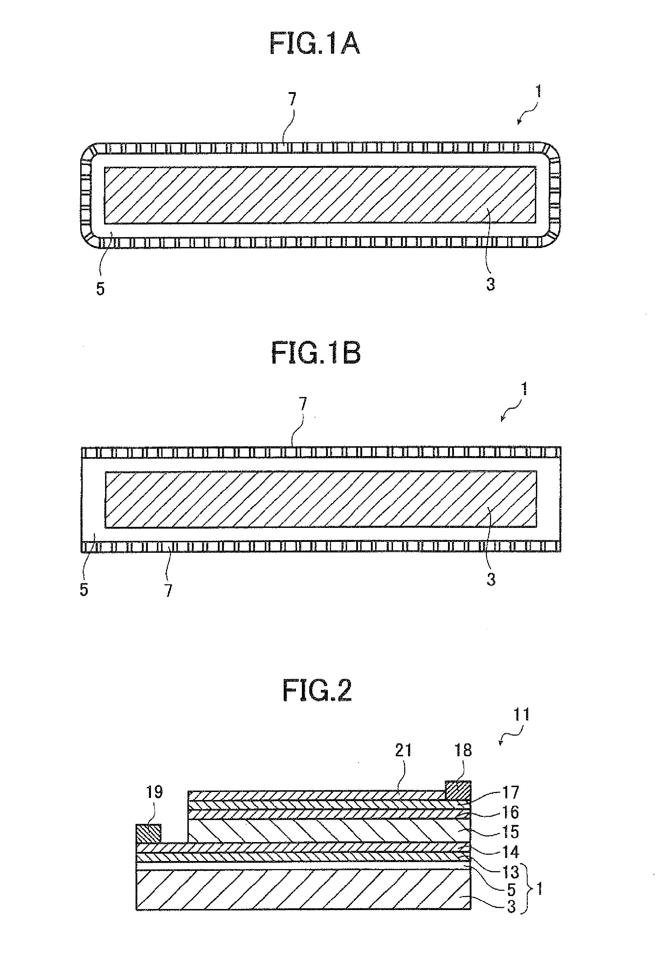

As shown in FIGS. 1A and 1B, the metal composite substrate of the present invention contains aluminum or an aluminum alloy on the whole surface of the core, but in cases where this substrate is used as a device substrate, part of the aluminum or aluminum alloy which is on the lateral surfaces or the bottom surface or has been anodized may be optionally removed by dissolution or cutting to expose part of the core to ambient air. This case is also included in the metal composite substrate of the present invention.

### 6. Method of Manufacturing Solar Cell

Solar cells are broadly classified into three types including (1) monocrystalline silicon solar cells, (2) polycrystalline silicon solar cells, and (3) thin-film solar cells. A flexible metal composite substrate as in the present invention is suitable to apply to a thin-film solar cell. There are two typical types of thin-film solar cells including thin-film silicon type and compound type depending on the type of light-absorbing layer.

A thin-film silicon substrate is obtained by a method of forming an amorphous or microcrystalline silicon thin film by CVD or other technique, and known compound type solar cells include GaAs solar cells and CIS (chalcopyrite) solar cells. CIS solar cells use compounds such as copper, indium, gallium, selenium and sulfur instead of silicon and are abbreviated as CIS, CIGS, CIGSS and the like depending on the compound used.

### Thin-Film Solar Cell

A thin-film solar cell can be manufactured by the roll-to-roll process using the inventive substrate. In other words, a metal composite substrate wound into a roll after having been molded so as to have a specified thickness travels from a feed roll to a take-up roll and the respective layers to be described later are sequentially formed or each layer is formed during the travel of the substrate from the feed roll to the take-up roll.

It is particularly preferred for the composite sheet used in the present invention to be anodized and sealed by the roll-to-roll process.

It is preferred to use a method in which the composite sheet taken up after the foregoing treatments have been carried out is fed again to sequentially form thereon the respective layers to be described layer, then cut to obtain solar cells. It is also preferred to use a method in which solar cells are formed after cutting the sheet having undergone anodizing treatment and sealing treatment.

FIG. 2 is a cross-sectional view showing an example of the general configuration of a thin-film solar cell 11 for which the substrate of the present invention can be used.

A metal composite substrate 1 of the present invention is used in which a film of aluminum or an aluminum alloy 5 is formed on a core 3 and its surface layer is anodized to form an anodized film 7 which serves as an insulating layer 13. A backside electrode layer 14 is then formed on the insulating layer 13, and a light-absorbing layer 15, a buffer layer 16, and a transparent electrode layer 17 are sequentially formed, with output electrodes 18 and 19 formed on the transparent electrode layer 17 and the backside electrode layer 14, respectively. The exposed portion of the transparent electrode layer 17 is coated with an antireflective film 21.

There is no particular limitation on the materials and thicknesses of the backside electrode layer 14, the light-absorbing layer 15, the buffer layer 16, the transparent electrode layer 17 and the output electrodes 18, 19 in the thin-film solar cell illustrated in FIG. 2. For example, the respective layers of the CIS or CIGS thin-film solar cell may be made of the following materials and have the thicknesses defined below.

The backside electrode layer 14 comprises an electrically-conductive material and has a thickness of 0.1 to 1 µm. Film deposition may be carried out by techniques commonly used in the manufacture of solar cells, as exemplified by sputtering and vapor deposition. The material is not particularly limited as long as it has electrical conductivity, and use may be made of a metal or a semiconductor having a volume resistivity of 6 × 10⁶ Ω·cm or less. More specifically, for example, Mo (molybdenum) may be deposited. The shape is not particularly limited and films may be deposited in an arbitrary shape in accordance with the required shape of the solar cell.

In order to increase the power generation efficiency, the light-absorbing layer 15 requires the function of efficiently absorbing light to excite electron-hole pairs and take out the excited electron-hole pairs without recombination. It is important to use one having a larger light absorption coefficient in order to obtain higher power generation efficiency. Silicon thin films such as amorphous silicon thin films and nanocrystalline silicon thin films or thin films made of various compounds are used for the light-absorbing layer 15. The type of compound is not limited and use may be made of compounds such as CdS/CdTe, CIS(Cu-In-Se), CIGS(Cu-In-Ga-Se), SiGe, CdSe, GaAs, GaN, and InP. The thin films made of these compounds can be formed by methods such as sintering, chemical deposition, sputtering, close-spaced sublimation, multi-source deposition and selenization.

A CdS/CdTe thin film is one obtained by sequentially stacking a CdS film and a CdTe film and is classified depending on the thickness of the CdS film into two types including (a) one having a thickness of about 20 µm and (b) one with a thickness of not more than 0.1 µm and having a transparent conductive film formed between this film and the substrate. In the structure of (a), CdS paste and CdTe paste are sequentially applied onto the substrate and sintered at a temperature of 600°C or less. In the structure of (b), the CdS film is formed by chemical deposition or sputtering and the CdTe film is formed by close-spaced sublimation.

The CIS or CIGS thin film uses a compound semiconductor and is characterized by the high stability with respect to the long-term use. The thin film made of any of these compounds has a thickness of, for example, 0.1 to 4 µm and is formed by applying a compound paste and sintering at a temperature of 350 to 550°C.

Film deposition may be carried out by techniques commonly used in the manufacture of solar cells, as exemplified by vapor deposition and selenization. An exemplary material includes a compound semiconductor material which contains main constituent elements including a Ib element, a IIIb element and a IVb element and has a chalcopyrite structure. For example, a p-type semiconductor layer containing Cu (copper), at least one element selected from In (indium) and Ga (gallium), and at least one element selected from Se (selenium) and S (sulfur) may be deposited for the light-absorbing layer. More specifically, CuInSe₂, Cu(In,Ga)Se₂, or other compound semiconductor in which part of selenium is substituted with sulfur may be deposited. A CIS or CIGS solar cell is obtained by such a manufacturing method, thus enabling the solar cell manufactured to have more excellent conversion efficiency.

Doping with zinc is also carried out in this step, and part of the layer should be doped with zinc in this case. Doping with zinc can be carried out so that the concentration of zinc contained increases from the electrode layer 14 side in the layer thickness direction (so as to have a concentration gradient). It is particularly preferred for the neighborhood on the opposite side from the electrode layer 14 to be doped with zinc. Such manufacturing method enables a solar cell having more excellent properties such as conversion efficiency to be manufactured. The neighborhood on the opposite side from the electrode layer 14 as used herein refers to the area which is, for example, about 3 nm to 30 nm distant from the opposite side surface. The doping distance is not necessarily constant for the whole area, and partial variability is acceptable. The amount of doping with zinc is not particularly limited and is in the range of 1 at% to 15 at%. The method of doping with zinc is not particularly limited. For example, doping with zinc may be carried out by ion irradiation. The doping distance and doping amount can be controlled by adjusting the energy of zinc ions to be irradiated. Doping with zinc may also be carried out by contact with a zinc-containing solution. The distance and amount of doping with zinc can be controlled by adjusting the concentration of the zinc-containing solution and the time for which the substrate is brought into contact with the solution. More uniform doping with zinc can be achieved by such a manufacturing method. The doping distance can be further decreased. Doping with zinc can be more simply carried out by the immersion process, thus enabling the manufacturing method used to be low in manufacturing cost. The zinc-containing solution is not particularly limited and may be, for example, a solution containing zinc ions. Specifically, it is desirable to use an aqueous solution containing at least one compound selected from the group consisting of, for example, sulfate of zinc (zinc sulfate), chloride of zinc (zinc chloride), iodide of zinc (zinc iodide), bromide of zinc (zinc bromide), nitrate of zinc (zinc nitrate) and acetate of zinc (zinc acetate). The concentration of the aqueous solution is not particularly limited. The aqueous solution desirably contains zinc ions at a concentration of 0.01 mol/L to 0.03 mol/L. At a concentration within this range, a better zinc-doped layer can be formed. The time of immersion in the zinc-containing solution is not particularly limited and may be set as appropriate for the required doping distance (or the necessary thickness of the zinc-doped layer).
It is preferred to further form a ZnMgO film with a thickness of 0.05 to 4 µm on the zinc-doped layer by sputtering.

The buffer layer 16 is a layer made of a ZnO/CdS material and has a total thickness of 0.05 to 4 µm.

Film deposition may be carried out by techniques commonly used in the manufacture of solar cells, as exemplified by vapor deposition and sputtering.

The transparent electrode layer 17 is made of a material such as aluminum-doped ZnO or ITO (indium tin oxide) and has a thickness of 0.1 to 0.3 µm. Film deposition may be carried out by techniques commonly used in the manufacture of solar cells, as exemplified by sputtering. For example, a translucent electrically-conductive material may be deposited. A film of indium tin oxide (ITO), ZnO, or both the materials may be deposited.

The output electrodes 18 and 19 are made of a material such as aluminum or nickel. In the case of forming the output electrodes, the material of these output electrodes is not particularly limited and materials commonly used for solar cells may be employed. For example, the output electrodes may be formed by disposing NiCr, Ag, Au, A1 or the like. A commonly used method may be employed in the formation of the output electrodes.

The substrate of the present invention exerts the same effects as the object of the present invention even when used for the substrate of not only CIGS or CIS solar cells but also monocrystalline silicon solar cells, polycrystalline silicon solar cells, thin-film silicon solar cells, HIT solar cells, CdTe solar cells, multi-junction solar cells, space solar cells, dye-sensitized solar cells, organic thin-film solar cells, and solar cells utilizing the semiconductor quantum dot.

### EXAMPLES

The present invention is described below by way of examples and comparative examples. However, the present invention should not be construed as being limited to the following examples. Unless otherwise specified, the percentages shown in Examples are expressed by weight.

Metallic materials (a stainless steel and steels) with a thickness of 100 µm were used for the core and the core was entirely coated with an aluminum alloy (aluminum purity: 99.9%) to a thickness of 70 µm by hot dipping.

As shown in Table 1, a stainless steel SUS304 was used for the cores in Examples 1 and 2, a heat resisting steel SUH309 for the cores in Examples 3 and 4, and a mild steel SS400 for the cores in Examples 5 and 6. The cores were passed through molten aluminum with an aluminum purity of 99.9% to which no elements were added, thereby farming composite materials with a thickness of 240 µm.

For comparison, an aluminum alloy, a stainless steel, a heat resisting steel and a mild steel which are not composite materials were used in Comparative Examples 1 to 5.

The surface of each sheet was rolled by a mirror-finished roll and finished to have a surface roughness Rₐ of 0.05 µm.

The surface was first washed with 15% sulfuric acid at a solution temperature of 30°C for 10 seconds, rinsed with water and subjected to DC anodization in oxalic acid (1 mol/L solution) to form an anodized film with a thickness of 20 µm. The anodized film formed was then rinsed with water.

Some samples were further subjected to DC anodization in boric acid (1 mol/L solution) at a voltage of 400 V, sealed in a thickness range of 400 nm, rinsed with water and dried.

Each substrate was bent to an angle of 180° to split the anodized film. The broken-out section was observed by an electron microscope in the same manner to measure the thickness of the anodized film.

The anodized film was found to be formed in Examples 1 to 6 in which the composite material was used and in Comparative Examples 1 and 2 in which not the composite material but a single aluminum sheet was used. On the other hand, the anodized film formed in Comparative Examples 3 to 5 cannot be measured.

**Table 1**

| | Core | Upper most surface | Oxalic acid- anodized film | Boric acid- anodized film |
|---|---|---|---|---|
| Example 1 | SUS304 | 99.9% Aluminum | 20 µm | None |
| Example 2 | SUS304 | 99.9%Aluminum | 20 µm | 400 nm |
| Example 3 | SUH309 | 99.9%Aluminum | 20 µm | None |
| Example 4 | SUH309 | 99.9%Aluminum | 20 µm | 400 nm |
| Example 5 | SS400 | 99.9%Aluminum | 20 µm | None |
| Example 6 | SS400 | 99.9%Aluminum | 20 µm | 400 nm |
| Comparative Example 1 | 99.9% Aluminum | - | 20 µm | None |
| Comparative Example 2 | 95.4% Al and 4.5% Mg | - | 20 µm | None |
| Comparative Example 3 | SUS304 | - | Impossible to produce | None |
| Comparative Example 4 | SUH309 | - | Impossible to produce | None |
| Comparative Example 5 | SS400 | - | Impossible to produce | None |

Then, each metal composite substrate was cut into a size of 300 mm x 300 mm and was evaluated for the surface insulating properties at 100 points. As a result, there was no problem of insulating properties in Examples 3 to 6 of the present invention and Comparative Examples 5 and 6. The insulating properties were determined based on a resistance value of at least 1 MQ which was regarded as good. The sample was rated good at a resistance value of 1 to 10 MΩ, excellent at a resistance value of 10 MΩ or more and poor at a resistance value less than 1 MΩ.

In addition, the complex metal substrate was heated at 550°C for 30 minutes and allowed to cool to room temperature and evaluated for the flatness on a glass plate. The flatness was evaluated by measuring the amount of uplift by a metal straightedge. When the amount of uplift was 3 mm or less, a taper gauge was used for the measurement. The composite materials in Examples 1 to 6, the stainless steel in Comparative Example 3, the heat resisting steel in Comparative Example 4 and the mild steel in Comparative Example 5 were found to have good flatness. The results are shown in Table 2.

**Table 2**

| | Flatness after heating | Insulating properties |
|---|---|---|
| Example 1 | Up to 1 mm | Good |
| Example 2 | Up to 1 mm | Excellent |
| Example 3 | 3 mm | Good |
| Example 4 | 3 mm | Excellent |
| Example 5 | 5 mm | Good |
| Example 6 | 5 mm | Excellent |
| Comparative Example 1 | 35 mm | Good |
| Comparative Example 2 | 16 mm | Good |
| Comparative Example 3 | 1 mm | Poor |
| Comparative Example 4 | 4 mm | Poor |
| Comparative Example 5 | 6 mm | Poor |

Then, metal composite substrates (with a size of 300 mm × 300 mm) having good or excellent insulating properties were used to prepare CIGS solar cells. To be more specific, the substrates in Examples 1 to 6 and Comparative Examples 1 and 2 were used.

An Mo layer was deposited on the anodized aluminum substrate by radio-frequency (RF) sputtering, which was followed by the formation of an NaF layer by RF sputtering and the formation of an Mo layer by RF sputtering. The thus deposited Mo/NaF/Mo multilayer film had a thickness of about 1.0 µm. A CuInGaSe₂ thin film was deposited on the Mo layer in the vacuum vessel. For the deposition of the CuInGaSe₂ thin film, a copper evaporation source, an indium evaporation source, a gallium evaporation source and a selenium evaporation source as the sources of the main ingredients of CuInGaSe₂ were prepared in the vacuum vessel. The crucibles as the copper, indium, gallium and selenium evaporation sources were heated at a degree of vacuum of about 10⁻⁷ Torr to evaporate the respective elements. In this process, the temperature of the crucibles was appropriately adjusted. The CuInGaSe₂ thin film was of a two-layer structure as described below. More specifically, the first layer was formed so that the copper atom composition exceeded the total atom composition of indium and gallium, and the second layer was formed so that the total atom composition of indium and gallium exceeded the copper atom composition, whereby the film of a two-layer structure was obtained. The substrate was kept at a temperature of 550°C. The first layer was vapor-deposited to a thickness of about 2 µm. In this process, the atom composition ratio of Cu/(In+Ga) was about 1.0 to 1.2. Then, the second layer was vapor-deposited to a thickness of about 1 µm so that the final atom composition ratio of Cu/(In+Ga) became 0.8 to 0.9.

Then, a multilayer semiconductor film was formed as the window layer. First, a CdS film with a thickness of about 50 nm was formed by a chemical deposition method. The chemical deposition method involved heating an aqueous solution containing cadmium nitrate, thiourea and ammonia to about 80°C and immersing the light-absorbing layer in the aqueous solution. Then, a ZnO film with a thickness of about 80 nm was formed on the CdS film by MOCVD.

Then, an aluminum-doped ZnO film with a thickness of about 200 nm was deposited by MOCVD as the transparent conductive film.

Finally, aluminum was vapor-deposited for the output electrodes to prepare a solar cell.

Simulated sunlight with an air mass (AM) of 1.5 and an intensity of 100 mW/cm² was used to evaluate the prepared solar cells for their properties and a conversion efficiency of 10.0% was obtained. This result shows that a solar cell formed by using an anodized aluminum substrate of the present invention also has a sufficiently high photoelectric conversion efficiency.

Plate warping and surface cracking occurred during the formation of the Mo layer in Comparative Example 1 and during the formation of the CIGS layer in Comparative Example 2, and therefore no solar cell could be obtained from the substrates in Comparative Examples 1 and 2. The results are shown in Table 3.

**Table 3**

| | Mo layer | CIGS layer | Power generation |
|---|---|---|---|
| Example 1 | No problem | No problem | Possible |
| Example 2 | No problem | No problem | Possible |
| Example 3 | No problem | No problem | Possible |
| Example 4 | No problem | No problem | Possible |
| Example 5 | No problem | Warping that occurred was within the allowable range | Possible |
| Example 6 | No problem | Warping that occurred was within the allowable range | Possible |
| Comparative Example 1 | Warping occurred and deposition was stopped | - | - |
| Comparative Example 2 | Warping that occurred was within the allowable range | Warping that occurred was outside the allowable range and deposition was stopped | - |

## Claims

1. A metal composite substrate comprising:
a core comprising a metal having higher strength than aluminum at elevated temperatures of at least 300°C; and
an aluminum or aluminum alloy layer covering an entire surface of the core,
wherein an anodized film is formed at a surface of the aluminum or aluminum alloy layer.

2. The metal composite substrate according to claim 1, wherein the core comprises a steel.

3. The metal composite substrate according to claim 1 or 2, wherein the anodized film is a porous anodized film with a thickness of 1 to 50 µm.

4. The metal composite substrate according to any one of claims 1 to 3, wherein the anodized film is further sealed in an aqueous boric acid solution.

5. A semiconductor substrate comprising the metal composite substrate according to any one of claims 1 to 4.

6. A solar cell comprising the metal composite substrate according to any one of claims 1 to 4.

7. A thin-film solar cell comprising:
the metal composite substrate according to any one of claims 1 to 4; and
a light-absorbing layer and an electrode layer formed on the metal composite substrate.

8. The thin-film solar cell according to claim 7, wherein the light-absorbing layer is formed on the metal composite substrate via a backside electrode layer and contains a compound selected from the group consisting of CdS/CdTe, CIS and CIGS.

9. A method of producing a metal composite substrate comprising:
plating an entire surface of a core comprising a metal having higher strength than aluminum at elevated temperatures of at least 300°C with aluminum or an aluminum alloy to form an aluminum or aluminum alloy layer; and
subjecting a surface of the aluminum or aluminum alloy layer to anodizing treatment, rinsing treatment and drying treatment.

10. The method according to claim 9, wherein the plating is hot-dip plating.
